# FASCICULE DE BREVET EUROPEEN

(11) **EP 3 781 514 B1**
(45) Date de publication et mention de la délivrance du brevet: **14.06.2023**
(21) Numéro de dépôt: 19772779.5
(22) Date de dépôt: 17.04.2019
(51) Int. Cl.: B81C 1/00

(54) **PROCÉDÉ DE BIO-FONCTIONNALISATION DE SURFACE**
VERFAHREN ZUR BIOFUNKTIONALISIERUNG VON OBERFLÄCHEN
SURFACE BIO-FUNCTIONALIZATION METHOD

(30) Priorité: 18.04.2018 FR 1853414
(43) Date de publication de la demande: 24.02.2021
(73) Titulaire: Centre national de la recherche scientifique, 75016 Paris (FR); Université d'Aix Marseille, 13007 Marseille 7 (FR)
(72) Inventeur: SENGUPTA, Kheya, 13009 Marseille (FR); BENARD, Emmanuelle, 13009 Marseille (FR); OZEROV, Igor, 13009 Marseille (FR); BEDU, Frédéric, 13009 Marseille (FR); DALLAPORTA, Hervé, 13008 Marseille (FR)
(74) Mandataire: INNOV-GROUP
(86) Numéro de dépôt international: PCT/FR2019/050915
(87) Numéro de publication internationale: WO 2019/202260

(56) Documents cités:
- US-A1- 2015 042 702
- Emmanuelle Benard ET AL: "Ligand Nano-cluster Arrays in a Supported Lipid Bilayer", Journal of visualized experiments, 23 avril 2017 (2017-04-23), XP055531684, DOI: 10.3791/55060> Extrait de l'Internet: URL:https://hal-amu.archives-ouvertes.fr/h al-01577346/document [extrait le 2018-12-07]
- TOMESCU ROXANA ET AL: "Technological studies for plasmonic metasurfaces", PROCEEDINGS OF SPIE; [PROCEEDINGS OF SPIE ISSN 0277-786X VOLUME 10524], SPIE, US, vol. 10010, 14 décembre 2016 (2016-12-14), pages 100101U-100101U, XP060079206, DOI: 10.1117/12.2243293 ISBN: 978-1-5106-1533-5

## Description

### DOMAINE DE L'INVENTION

La présente invention concerne le domaine de la bio-fonctionnalisation de surface par nanolithographie, pour application en biologie, en chimie, et plus généralement en biochimie, par microscopie optique de ladite surface.

Dans le domaine de la nanolithographie, il est connu par exemple le document EP2736635, qui vise à réaliser des motifs de nanoparticules métalliques sur un substrat. Typiquement, les nanoparticules métalliques sont en or et le substrat est un oxyde inorganique à haut indice de réfraction optique (par exemple TiO₂, ZnO...).

Il est également connu le document US9180519 qui décrit une méthode de fabrication de nano structures distribuées selon un motif prédéterminé afin d'y accrocher une cible, que ce soit pour des dispositifs optiques ou biologiques. Les nano structures sont typiquement des nano plots en or.

D'autres documents sont connus, par exemple US2005046758, WO2014052759, ou encore la publication « Nanometric Protein-Patch Arrays on Glass and Polydimethylsiloxane for Cell Adhesion Studies », F. Pi et al., Nano Lett. 2013, 13, 3372-3378. Cependant, tous ces documents prévoient de réaliser des nano structures métalliques (également appelées nano plots, îlots ou nanoparticules) permettant l'accrochage de protéines, en particulier en or.

Emmanuelle Benard ET AL: "Ligand Nano-cluster Arrays in a Supported Lipid Bilayer", Journal of visualized experiments, 23 avril 2017, divulgue un procédé de traitement de surface d'une plaque de verre, pour l'observation par microscopie optique de ladite plaque, comportant une étape consistant à fonctionnaliser la surface de la plaque de diélectrique par dépôt d'une couche de protéines afin de réaliser un ensemble d'îlots de protéines.

Or la présence de telles nano structures métalliques posent des problèmes en microscopie optique, par exemple par des effets optiques non linéaires.

La présente invention permet de résoudre ce problème.

### RESUME DE L'INVENTION

Plus précisément, l'invention concerne un procédé de traitement de surface d'une plaque de diélectrique transparent à la lumière visible, pour l'observation par microscopie optique de ladite plaque de diélectrique.

Le procédé selon l'invention comprend les étapes consistant à :
- déposer sur ladite plaque un film négatif comprenant une composition polymérisable qui polymérise lorsqu'elle est exposée à un faisceau d'électrons,
- polymériser la composition du film négatif en un ensemble de points représentant un motif prédéterminé, par exposition dudit film négatif à un faisceau d'électrons,
- développer le film négatif par dissolution de la composition non polymérisée et obtenir un ensemble de plots de composition polymérisée, chaque plot correspondant à un point du motif prédéterminé,
- déposer un film de métal sur le film négatif de la surface de la plaque, et
- solubiliser le film négatif développé, pour obtenir un film de métal percé de trous, chaque trou du film de métal correspondant à la base d'un plot. Un procédé comportant lesdites étapes est déjà connu du document US 2015/042702 A1.

La présente invention se caractérise en ce qu'on prévoit en outre une étape consistant à :
- fonctionnaliser la surface de la plaque de diélectrique par dépôt d'une monocouche de protéines dans les trous du film de métal, pour réaliser un ensemble d'îlots de protéines, chaque îlot étant disposé dans un trou du film de métal respectif.

On peut prévoir en outre, préalablement à l'étape de fonctionnalisation, une étape consistant à :
- déposer un primaire d'accrochage dans les trous du film de métal.

On peut prévoir en outre une étape consistant à :
- dissoudre le film de métal.

On peut prévoir en outre une étape consistant à :
- passiver la surface de la plaque par une couche de passivation entre les îlots de protéines.

On peut prévoir en outre une étape consistant à :
- Mettre en contact la surface de la plaque passivée et un premier ensemble d'au moins une protéine fonctionnelle susceptible de réagir avec les protéines des îlots.

On peut prévoir en outre une étape consistant à :
- Fonctionnaliser la couche de passivation par un deuxième ensemble d'au moins une protéine fonctionnelle, les protéines du deuxième ensemble étant différentes des protéines du premier ensemble.

On peut prévoir en outre une étape consistant à :
- déposer un promoteur d'accroche sur la surface de la plaque préalablement au dépôt du film négatif.

On peut prévoir que l'exposition du film négatif à un faisceau d'électrons est mise en œuvre à température constante prédéterminée.

On peut prévoir que l'étape de dépôt du film de métal sur la surface de la plaque est mise en oeuvre par évaporation ou par pulvérisation, l'épaisseur du film de métal étant inférieure à celle du film négatif.

Grâce à l'invention, les îlots de protéines sont disposés selon un motif prédéterminé dont la surface totale peut représenter de quelques micromètres carrés jusqu'à 1 ou 2 mm².

Chaque îlot 70 de protéines peut présenter un diamètre équivalent aussi petit que 50 nm. Les îlots peuvent être disposés en réseau dont le pas est aussi petit que 100 nm. Ainsi, quand une cellule biologique est posée sur une plaque support, elle est en contact avec une pluralité d'îlots de protéines. La présente invention comprend également une plaque de diélectrique transparent selon la revendication 15.

D'autres caractéristiques et avantages de la présente invention apparaîtront plus clairement à la lecture de la description suivante donnée à titre d'exemple illustratif et non limitatif et faite en référence aux figures annexées.

### DESCRIPTIF DES DESSINS

la figure 1A illustre une plaque de diélectrique transparent à la lumière visible,
la figure 1B illustre une coupe transversale selon l'axe A-A de la figure 1A,
la figure 2A illustre la plaque de la figure 1A après dépôt d'une couche de promoteur d'accroche,
la figure 2B illustre une coupe transversale selon l'axe A-A de la figure 2A,
la figure 3A illustre la plaque de la figure 2A après dépôt d'un film négatif,
la figure 3B illustre une coupe transversale selon l'axe A-A de la figure 3A,
la figure 4A illustre la plaque de la figure 3A après exposition à un faisceau d'électrons,
la figure 4B illustre une coupe transversale selon l'axe A-A de la figure 4A,
la figure 5A illustre la plaque de la figure 4A après développement du film négatif,
la figure 5B illustre une coupe transversale selon l'axe A-A de la figure 5A,
la figure 6A illustre la plaque de la figure 5A après dépôt d'un film de métal,
la figure 6B illustre une coupe transversale selon l'axe A-A de la figure 6A,
la figure 7A illustre la plaque de la figure 6A après dissolution du film négatif,
la figure 7B illustre une coupe transversale selon l'axe A-A de la figure 7A,
la figure 8A illustre la plaque de la figure 7A après fonctionnalisation,
la figure 8B illustre une coupe transversale selon l'axe A-A de la figure 8A,
la figure 9A illustre la plaque de la figure 8A après dissolution du film de métal,
la figure 9B illustre une coupe transversale selon l'axe A-A de la figure 9A,
la figure 10A illustre la plaque de la figure 9A après passivation,
la figure 10B illustre une coupe transversale selon l'axe A-A de la figure 10A,
la figure 11A illustre la plaque de la figure 10A après fonctionnalisation,
la figure 11B illustre une coupe transversale selon l'axe A-A de la figure 11A,
la figure 12A illustre la plaque de la figure 11A après fonctionnalisation de la couche de passivation, et
la figure 12B illustre une coupe transversale selon l'axe A-A de la figure 12A.

### DESCRIPTION DETAILLEE

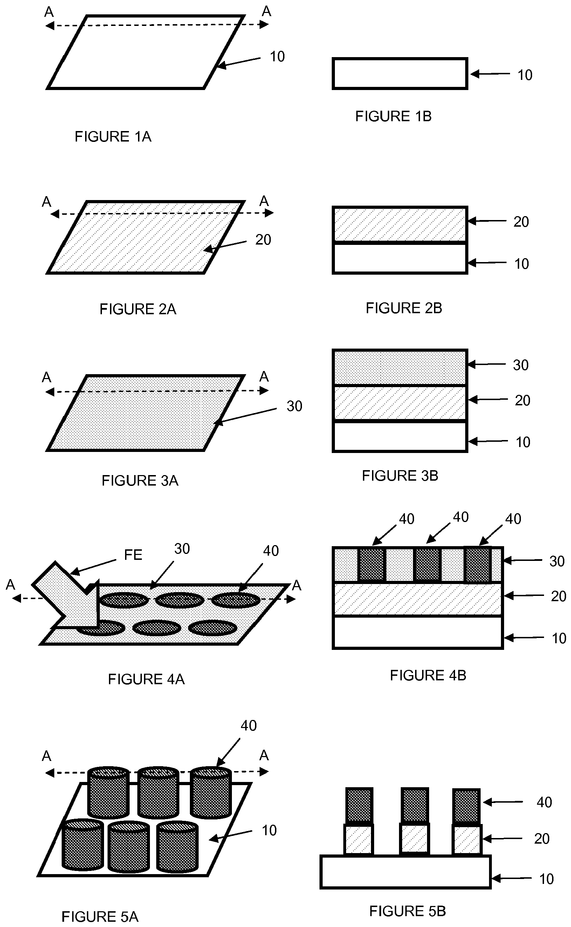

La présente invention consiste en un traitement de surface d'une plaque 10 de diélectrique transparent à la lumière visible, pour l'observation par microscopie optique de ladite plaque de diélectrique, en l'espèce une plaque de verre (figure 1B), ci-après « plaque » par concision.

Par concision, la plaque 10 de diélectrique transparent à la lumière visible, qui sert de support, est appelée « plaque » ci-après.

On peut prévoir optionnellement de déposer une couche de promoteur d'accroche 20, uniformément sur la surface de la plaque 10 (figure 2B).

Ensuite, on prévoit de déposer sur la plaque 10 un film négatif 30 comprenant une composition polymérisable qui polymérise lorsqu'elle est exposée à un faisceau d'électrons (figure 3B), par exemple une composition comprenant un solvant organique, des chaînes de polymères en solution et des molécules d'agent de liaison, le catalyseur facilitant de la réaction de polymérisation, ou encore le film AR-N 7520-18 de la société ALLRESIST. De préférence, le film négatif 30 est déposé selon de sorte à présenter une épaisseur uniforme sur la surface de la plaque 10, par exemple par enduction centrifuge.

De préférence, l'exposition du film négatif 30 à un faisceau d'électrons est mise en oeuvre à température constante prédéterminée.

On peut ensuite exposer le film négatif 30 à un faisceau d'électrons FE (figure 4A) en un ensemble de points afin de représenter un motif prédéterminé, typiquement un motif de réseau.

Chaque point de contact entre le faisceau d'électrons FE et le film négatif 30 permet de polymériser la composition du film négatif 30 au droit du point de contact, ce qui créé un cylindre ou plot de composition polymérisée 40. Par exemple la composition est une résine.

Une fois le motif prédéterminé entièrement représenté, on prévoit de développer le film négatif 30 pour solubiliser la composition non polymérisée, par exemple par immersion dans un solvant.

On obtient ainsi un ensemble de plots de résine polymérisée, chaque plot correspondant à un point du motif prédéterminé (figure 5A).

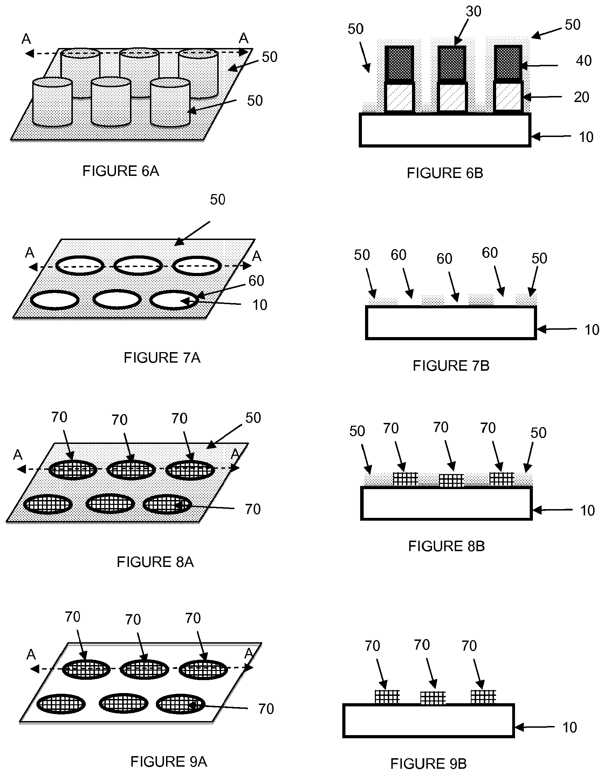

On peut alors prévoir de déposer un film (ou couche) de métal 50 sur le film négatif de la surface de la plaque (figure 6A), ce qui forme un masque qui sert de motif aux îlots 70 de protéines décrits ultérieurement.

En l'espèce, le dépôt est réalisé par évaporation ou par pulvérisation. En l'espèce, le métal est de l'aluminium.

De préférence, l'épaisseur du film de métal 50 est inférieure à celle du film négatif 30. Autrement dit, la hauteur des plots 40 est supérieure à l'épaisseur du film de métal 50 (figure 6B).

On peut prévoir que le ratio entre l'épaisseur du film de métal et l'épaisseur du film négatif 30 est supérieur à une valeur seuil.

On peut alors solubiliser le film de résine 30. En l'espèce, la dissolution est réalisée par trempage dans un bain de solvant organique adapté à la composition polymérisable. La solubilisation du film de résine 30, c'est-à-dire des plots 40, entraine le décollement du film de métal 50 sur les plots 40 mais pas entre les plots 40. Ainsi, après solubilisation, le film de métal 50 sur la surface extérieure de la plaque 10 présente des trous 60 à la place des plots 40 et une épaisseur constante autrement (figure 7B).

Chaque trou 60 correspond donc à la base d'un plot 40.

A ce stade le temps de conservation de la plaque 10 peut être de plusieurs mois.

On prévoit alors de fonctionnaliser la surface de la plaque 10 par dépôt d'une couche de protéines fonctionnelles, par exemple une monocouche, par exemple par incubation dans un bain protéique, dans les trous 60 du film de métal, pour réaliser un ensemble d'îlots 70 de protéines, chaque îlot 70 de protéines étant disposé dans un trou 60 du film de métal respectif (figure 8B) ; la fonctionnalisation comprenant typiquement une étape de rinçage.

En l'espèce la monocouche de protéines est une monocouche d'albumine de sérum bovin marquée par une étiquette, en l'espèce la biotine (vitamine H).

A cet effet, on prévoit de préférence de déposer un primaire d'accrochage (non illustré) dans les trous 60 du film de métal 50 préalablement au dépôt d'une monocouche de protéines, par exemple par évaporation ou en plongeant la plaque 10 dans une solution aqueuse.

Le primaire d'accrochage est par exemple une molécule permettant d'établir à la fois des liaisons covalentes avec le verre de la plaque 10 et permettant de servir d'accrochage avec des protéines prédéterminées, en l'espèce une molécule de type amino silane.

Chaque îlot 70 de protéines peut présenter un diamètre équivalent aussi petit que 50 nm. Selon le motif prédéterminé choisi, les îlots 70 de protéines peuvent être disposés en réseau dont le pas est aussi petit que 100 nm.

Ainsi, quand une cellule biologique est posée sur une plaque support fonctionnalisée selon l'invention, elle peut être en contact avec une pluralité d'îlots 70 de protéines.

Une cellule biologique en contact avec une plaque fonctionnalisée selon l'invention réagit différemment non seulement en fonction du motif (notamment du diamètre équivalent des îlots, de la densité des îlots et du pas du réseau) mais aussi en fonction de la nature des protéines des îlots. Ainsi, de préférence, tous les îlots 70 de protéines comprennent les mêmes protéines.

On peut prévoir ensuite de dissoudre le film de métal 50 (figure 9A, figure 9B), en l'espèce dans un bain de soude. L'avantage de l'aluminium est qu'il est dissout par de la soude alors que les protéines des îlots 70 de protéines ne sont pas attaquées par la soude.

Ainsi, à la suite de la dissolution du film de métal 50, il ne reste sur la surface de la plaque 10 que des nano plots de protéines, c'est à dire les protéines des îlots 70 de protéines, accrochés directement sur la surface de la plaque 10 ou via le promoteur d'accroche 20, c'est à dire sans nano structures métalliques qui vient en outre interférer avec la lumière d'un microscope optique.

Ainsi, contrairement à l'art antérieur cité en début de description, grâce à la présente invention, il ne reste aucun nano plot métallique entre les îlots 70 de protéines et la surface de la plaque 10.

A ce stade, le temps de conservation de la plaque 10 peut être de plusieurs jours.

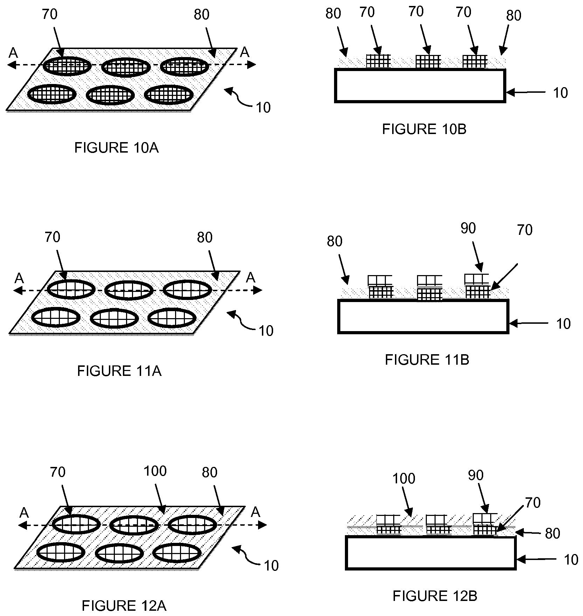

On peut prévoir également de passiver la surface de la plaque 10 par une couche de passivation 80 entre les îlots 70 de protéines (figure 10A, figure 10B), par exemple par une couche organique, une couche de polymère, une couche lipidique (en l'espèce une double couche lipidique) ou une autre protéine. La passivation peut être mise en oeuvre par exemple par dépôt ou bain et adsorption d'une couche de passivation, inerte au regard des protéines marquées, ce qui permet de garantir que les protéines actives de l'étape de fonctionnalisation ci-après ne se lient qu'avec les protéines marquées des îlots.

On peut alors finaliser la fonctionnalisation de la surface de la plaque 10 en mettant en contact la surface de la plaque 10, éventuellement passivée, avec un premier ensemble d'au moins une protéine fonctionnelle 90 susceptible de réagir avec les protéines des îlots 70 de protéines (figure 11A, figure 11B), par exemple des anticorps, éventuellement via une protéine intermédiaire de liaison.

Le premier ensemble d'au moins une protéine fonctionnelle 90 permet l'étude de cellules biologiques vivantes mises en contact avec la surface de la plaque 10, notamment par microscopie optique.

Une plaque 10 fonctionnalisée selon la présente invention peut se présenter sous forme de laboratoire sur puce.

A ce stade le temps de conservation de la plaque 10 peut être de plusieurs heures.

La présente invention n'est pas limitée aux modes de réalisation précédemment décrits.

Par exemple, on peut prévoir de fonctionnaliser également la couche de passivation 80 (figure 12A, figure 12B).

A cet effet, on peut prévoir un deuxième ensemble d'au moins une protéine fonctionnelle 100, les protéines du deuxième ensemble 100 étant différentes des protéines du premier ensemble 90 et de préférence ne sont pas susceptibles de réagir avec les protéines des îlots 70 de protéines.

Par exemple, pour des cellules immunitaires (cellules T), on prévoit que le premier ensemble est un récepteur et que le deuxième ensemble est un co-récepteur.

Grâce à l'invention, plusieurs îlots 70 de protéines peuvent être fabriqués simultanément.

### Nomenclature

- 10: plaque de diélectrique transparent à la lumière visible
- 20: promoteur d'accroche
- 30: film négatif qui polymérise lorsqu'il est exposé à un faisceau d'électrons
- 40: plot de résine polymérisée
- 50: film de métal
- 60: Trou dans le film de métal 50
- 70: îlot de protéines
- 80: couche de passivation
- 90: premier ensemble de protéines fonctionnelles, susceptibles de réagir avec les protéines des îlots de protéines 70
- 100: deuxième ensemble de protéines fonctionnelles

## Revendications

1. Procédé de traitement de surface d'une plaque (10) de diélectrique transparent à la lumière visible, pour l'observation par microscopie optique de ladite plaque de diélectrique, comprenant des étapes consistant à :
- déposer sur ladite plaque (10) un film négatif (30) comprenant une composition polymérisable qui polymérise lorsqu'elle est exposée à un faisceau d'électrons,
- polymériser la composition du film négatif (30) en un ensemble de points représentant un motif prédéterminé, par exposition dudit film négatif à un faisceau d'électrons,
- développer le film négatif (30) par dissolution de la composition non polymérisée et obtenir un ensemble de plots (40) de composition polymérisée, chaque plot (40) correspondant à un point du motif prédéterminé,
- déposer un film de métal (50) sur le film négatif (30) de la surface de la plaque (10), et
- solubiliser le film négatif (30) développé, pour obtenir un film de métal (50) percé de trous, chaque trou (60) du film de métal (50) correspondant à la base d'un plot (40),
**caractérisé en ce qu'**il comprend en outre une étape consistant à :
- fonctionnaliser la surface de la plaque de diélectrique par dépôt d'une monocouche de protéines dans les trous (60) du film de métal (50), pour réaliser un ensemble d'îlots (70) de protéines, chaque îlot (70) étant disposé dans un trou (60) respectif du film de métal (50).

2. Procédé selon la revendication 1, comprenant en outre, préalablement à l'étape de fonctionnalisation, une étape consistant à :
- déposer un primaire d'accrochage dans les trous (60) du film de métal (50).

3. Procédé selon l'une quelconque des revendications précédentes, comprenant en outre une étape consistant à :
- dissoudre le film de métal.

4. Procédé selon l'une quelconque des revendications précédentes, comprenant en outre une étape consistant à :
- passiver la surface de la plaque par une couche de passivation (80) entre les îlots (70) de protéines.

5. Procédé selon la revendication 4, comprenant en outre une étape consistant à :
- Mettre en contact la surface de la plaque (10) passivée et un premier ensemble (90) d'au moins une protéine fonctionnelle susceptible de réagir avec les protéines des îlots.

6. Procédé selon la revendication 5, comprenant en outre une étape consistant à :
- Fonctionnaliser la couche de passivation (80) par un deuxième ensemble (100) d'au moins une protéine fonctionnelle, les protéines du deuxième ensemble étant différentes des protéines du premier ensemble.

7. Procédé selon l'une quelconque des revendications précédentes, comprenant en outre une étape consistant à :
- déposer un promoteur d'accroche sur la surface de la plaque préalablement au dépôt du film négatif.

8. Procédé selon l'une quelconque des revendications précédentes, dans lequel l'exposition du film négatif à un faisceau d'électrons est mise en oeuvre à température constante prédéterminée.

9. Procédé selon l'une quelconque des revendications précédentes, dans lequel :
- L'étape de dépôt du film de métal sur la surface de la plaque est mise en oeuvre par évaporation ou par pulvérisation, l'épaisseur du film de métal (50) étant inférieure à celle du film négatif (30).

10. Procédé selon l'une quelconque des revendications précédentes, dans lequel l'étape consistant à fonctionnaliser la surface de la plaque (10) par dépôt d'une monocouche de protéines, comprend une étape d'incubation dans un bain protéique, et une étape de rinçage.

11. Procédé selon l'une quelconque des revendications précédentes, dans lequel la monocouche de protéines est une monocouche d'albumine de sérum bovin marquée par une étiquette, en l'espèce la biotine (vitamine H).

12. Procédé selon l'une quelconque des revendications précédentes, dans lequel chaque îlot (70) de protéines présente un diamètre équivalent aussi petit que 50 nm ; les îlots (70) de protéines peuvent être disposés en réseau dont le pas est aussi petit que 100 nm.

13. Procédé selon l'une quelconque des revendications précédentes, comprenant en outre une étape consistant à poser une cellule biologique sur la plaque (10) support fonctionnalisée, ladite cellule biologique pouvant ainsi être en contact avec une pluralité d'îlots (70) de protéines.

14. Procédé selon l'une quelconque des revendications 11 à 13, en dépendance de la revendication 4, dans lequel l'étape consistant à passiver la surface de la plaque (10) par une couche de passivation (80) entre les îlots (70) de protéines, est mise en oeuvre par une couche organique, une couche de polymère, une couche lipidique, une double couche lipidique ou une autre protéine ; ladite couche de passivation (80) étant inerte au regard des protéines marquées.

15. Plaque (10) de diélectrique transparent à la lumière visible, pour l'observation par microscopie optique de ladite plaque de diélectrique, ladite plaque (10) étant fonctionnalisée par le procédé selon l'une quelconque des revendications précédentes et se présente sous la forme de laboratoire sur puce.

## Patentansprüche

1. Verfahren zur Behandlung der Oberfläche einer für sichtbares Licht transparenten dielektrischen Platte (10) zum Beobachten der dielektrischen Platte mittels optischer Mikroskopie, das Schritte umfasst, die aus Folgendem bestehen:
- dem Abscheiden eines Negativfilms (30), der eine polymerisierbare Zusammensetzung umfasst, die polymerisiert, wenn sie einem Elektronenstrahl ausgesetzt wird, auf der Platte (10),
- dem Polymerisieren der Zusammensetzung des Negativfilms (30) an einem Satz von Punkten, die ein vorbestimmtes Motiv darstellen, durch eine Exposition des Negativfilms gegenüber einem Elektronenstrahl,
- dem Entwickeln des Negativfilms (30) durch das Auflösen der unpolymerisierten Zusammensetzung und dem Erhalt eines Satzes von Pads (40) aus polymerisierter Zusammensetzung, wobei jedes Pad (40) einem Punkt des vorbestimmten Motivs entspricht,
- dem Abscheiden eines Metallfilms (50) auf dem Negativfilm (30) der Oberfläche der Platte (10) und
- dem Löslichmachen des entwickelten Negativfilms (30), wodurch ein mit Löchern versehener Metallfilm (50) erhalten wird, wobei jedes Loch (60) des Metallfilms (50) der Basis eines Pads (40) entspricht,
**dadurch gekennzeichnet, dass** es darüber hinaus einen Schritt umfasst, der aus Folgendem besteht:
- dem Funktionalisieren der Oberfläche der dielektrischen Platte durch die Abscheidung einer Proteinmonoschicht in den Löchern (60) des Metallfilms (50), wodurch ein Satz von Proteininseln (70) hergestellt wird, wobei jede Insel (70) in einem jeweiligen Loch (60) des Metallfilms (50) abgeschieden ist.

2. Verfahren nach Anspruch 1, das weiterhin vor dem Funktionalisierungsschritt einen Schritt umfasst, der aus Folgendem besteht:
- dem Abscheiden einer Haftgrundierung in den Löchern (60) des Metallfilms (50).

3. Verfahren nach einem der vorhergehenden Ansprüche, das weiterhin einen Schritt umfasst, der aus Folgendem besteht:
- dem Auflösen des Metallfilms.

4. Verfahren nach einem der vorhergehenden Ansprüche, das weiterhin einen Schritt umfasst, der aus Folgendem besteht:
- dem Passivieren der Oberfläche der Platte durch eine Passivierungsschicht (80) zwischen den Proteininseln (70).

5. Verfahren nach Anspruch 4, das weiterhin einen Schritt umfasst, der aus Folgendem besteht:
- dem In-Kontakt-Bringen der Oberfläche der passivierten Platte (10) und eines ersten Satzes (90) mit mindestens einem funktionellen Protein, das mit den Proteinen der Inseln regieren kann.

6. Verfahren nach Anspruch 5, das weiterhin einen Schritt umfasst, der aus Folgendem besteht:
- dem Funktionalisieren der Passivierungsschicht (80) durch einen zweiten Satz (100) mindestens eines funktionellen Proteins, wobei die Proteine des zweiten Satzes von den Proteinen des ersten Satzes verschieden sind.

7. Verfahren nach einem der vorhergehenden Ansprüche, das weiterhin einen Schritt umfasst, der aus Folgendem besteht:
- dem Abscheiden eines Haftungsvermittlers auf der Oberfläche der Platte vor dem Abscheiden des Negativfilms.

8. Verfahren nach einem der vorhergehenden Ansprüche, wobei die Exposition des Negativfilms gegenüber einem Elektronenstrahl bei einer vorbestimmten konstanten Temperatur erfolgt.

9. Verfahren nach einem der vorhergehenden Ansprüche, wobei:
- der Schritt des Abscheidens des Metallfilms auf der Oberfläche der Platte durch Aufdampfen oder Aufsprühen erfolgt, wobei die Dicke des Metallfilms (50) kleiner als diejenige des Negativfilms (30) ist.

10. Verfahren nach einem der vorhergehenden Ansprüche, wobei der aus dem Funktionalisieren der Oberfläche der Platte (10) durch das Abscheiden einer Proteinmonoschicht bestehende Schritt einen Schritt einer Inkubation in einem Proteinbad und einem Spülschritt besteht.

11. Verfahren nach einem der vorhergehenden Ansprüche, wobei es sich bei der Proteinmonoschicht um eine Rinderserumalbumin-Monoschicht handelt, die mit einem Marker, in vorliegenden Fall Biotin (Vitamin H), markiert ist.

12. Verfahren nach einem der vorhergehenden Ansprüche, wobei jede Proteininsel (70) einen Äquivalenzdurchmesser aufweist, der nur 50 nm beträgt; wobei die Proteininseln (70) in einem Raster angeordnet sein können, dessen Teilung nur 100 nm beträgt.

13. Verfahren nach einem der vorhergehenden Ansprüche, das weiterhin einen Schritt umfasst, der aus dem Anordnen einer biologischen Zelle auf der funktionalisierten Trägerplatte (10) besteht, wobei die biologische Zelle sich auch in Kontakt mit mehreren Proteininseln (70) befinden kann.

14. Verfahren nach einem der Ansprüche 11 bis 13 in Abhängigkeit von Anspruch 4, wobei der Schritt, der aus einem Passivieren der Oberfläche der Platte (10) durch eine Passivierungsschicht (80) zwischen den Proteininseln (70) besteht, mittels einer organischen Schicht, einer Polymerschicht, einer Lipidschicht, einer Lipiddoppelschicht oder einem anderen Protein erfolgt; wobei die Passivierungsschicht (80) in Bezug auf die markierten Proteine inert ist.

15. Für sichtbares Licht transparente dielektrische Platte (10) zum Beobachten der dielektrischen Platte mittels optischer Mikroskopie, wobei die Platte (10) durch das Verfahren nach einem der vorhergehenden Ansprüche funktionalisiert ist und in Form eines Lab-on-a-Chip vorliegt.

## Claims

1. Method for the surface treatment of a dielectric plate (10) which is transparent to visible light, for the observation by optical microscopy of said dielectric plate, comprising stages consisting in:
- depositing, on said plate (10), a negative film (30) comprising a polymerizable composition which polymerizes when it is exposed to an electron beam,
- polymerizing the composition of the negative film (30) to give a set of points representing a predetermined pattern, by exposure of said negative film to an electron beam,
- developing the negative film (30) by dissolution of the non-polymerized composition and obtaining a set of studs (40) of polymerized composition, each stud (40) corresponding to a point of the predetermined pattern,
- depositing a metal film (50) on the negative film (30) of the surface of the plate (10), and
- dissolving the developed negative film (30), in order to obtain a metal film (50) pierced with holes, each hole (60) of the metal film (50) corresponding to the base of a stud (40),
**characterized in that** it additionally comprises a stage consisting in:
- functionalising the surface of the dielectric plate by deposition of a monolayer of proteins in the holes (60) of the metal film (50), in order to produce a set of islets (70) of proteins, each islet (70) being positioned in a respective hole (60) of the metal film (50).

2. Method according to Claim 1, additionally comprising, prior to the functionalisation stage, a stage consisting in:
- depositing a tie primer in the holes (60) of the metal film (50).

3. Method according to either one of the preceding claims, additionally comprising a stage consisting in:
- dissolving the metal film.

4. Method according to any one of the preceding claims, additionally comprising a stage consisting in:
- passivating the surface of the plate with a passivation layer (80) between the islets (70) of proteins.

5. Method according to Claim 4, additionally comprising a stage consisting in:
- bringing the passivated surface of the plate (10) into contact with a first set (90) of at least one functional protein capable of reacting with the proteins of the islets.

6. Method according to Claim 5, additionally comprising a stage consisting in:
- functionalising the passivation layer (80) with a second set (100) of at least one functional protein, the proteins of the second set being different from the proteins of the first set.

7. Method according to any one of the preceding claims, additionally comprising a stage consisting in:
- depositing a tie promoter on the surface of the plate prior to the deposition of the negative film.

8. Method according to any one of the preceding claims, in which the exposure of the negative film to an electron beam is carried out at a predetermined constant temperature.

9. Method according to any one of the preceding claims, in which:
- the stage of deposition of the metal film on the surface of the plate is carried out by evaporation or by sputtering, the thickness of the metal film (50) being less than that of the negative film (30).

10. Method according to any one of the preceding claims, in which the stage consisting in functionalising the surface of the plate (10) by deposition of a monolayer of proteins comprises a stage of incubation in a protein bath, and a rinsing stage.

11. Method according to any one of the preceding claims, in which the monolayer of proteins is a monolayer of bovine serum albumin marked with a label, in this case biotin (vitamin H).

12. Method according to any one of the preceding claims, in which each islet (70) of proteins exhibits an equivalent diameter as small as 50 nm; it being possible for the islets (70) of proteins to be arranged in a network, the pitch of which is as small as 100 nm.

13. Method according to any one of the preceding claims, additionally comprising a stage consisting in placing a biological cell on the functionalised support plate (10), it being possible for said biological cell to thus be in contact with a plurality of islets (70) of proteins.

14. Method according to any one of Claims 11 to 13, in dependence on Claim 4, in which the stage consisting in passivating the surface of the plate (10) with a passivation layer (80) between the islets (70) of proteins is carried out with an organic layer, a polymer layer, a lipid layer, a lipid bilayer or another protein; said passivation layer (80) being inert with respect to the marked proteins.

15. Dielectric plate (10) which is transparent to visible light, for the observation by optical microscopy of said dielectric plate, said plate (10) being functionalised by the method according to any one of the preceding claims and being provided in the lab-on-a-chip form.
